Europäisches Patentamt

European Patent Office

Office européen des brevets

(11) Publication number: **0 373 627**
**A1**

## EUROPEAN PATENT APPLICATION

(21) Application number: 89123055.9

(22) Date of filing: 13.12.89

(51) Int. Cl.5: **H02B 1/052**

(30) Priority: 13.12.88 JP 162114/88 U

(43) Date of publication of application:
**20.06.90 Bulletin 90/25**

(84) Designated Contracting States:
**AT BE CH DE ES FR GB GR IT LI NL SE**

(71) Applicant: **OMRON TATEISI ELECTRONICS CO.**
**10, Tsuchido-cho Hanazono Ukyo-ku Kyoto-shi Kyoto-fu(JP)**

(72) Inventor: **Tsuji, Hideaki Omron Tateisi Electronics Co.**
**Patent Dept. 20 Igadera Shimokaiinji Nagaokakyo-shi Kyoto-fu(JP)**

(74) Representative: **Wilhelms, Rolf E., Dr. et al WILHELMS, KILIAN & PARTNER Patentanwälte Eduard-Schmid-Strasse 2 D-8000 München 90(DE)**

(54) Mounting structure for electric devices.

(57) In a structure for mounting an electric device such as an electromagnetic relay on a mounting rail having a pair of flanges on either side thereof, a base member carrying the electric device is provided with a first pawl for engagement with one of the flanges and a slider slidably supported by the base is provided with a second pawl for engagement with the other flange of the mounting rail. The slider can move away from and toward the first engagement pawl and is normally urged toward the first engagement pawl by a spring member to permit snap mount of the electric device on the mounting rail. This spring member consists of an elastic extension member extending from the slider away from the first engagement pawl and is curved into a recess provided in the mounting surface, and a free end of the elastic extension member abuts an inner surface of the recess. Since the elastic extension member is integrally provided in the slider and extends into the mounting surface so as to deform in a plane perpendicular to the mounting surface, the mounting structure can be simplified and the lateral dimension of the mounting structure can be minimized.

*FIG. 1*

# MOUNTING STRUCTURE FOR ELECTRIC DEVICES

## TECHNICAL FIELD

The present invention relates to a mounting structure for electric devices which may be used to detachably mount electric devices such as electromagnetic relays on a mounting rail having flanges on either side thereof.

## BACKGROUND OF THE INVENTION

According to a conventionally known structure of this kind for mounting an electric device such as an electromagnetic relay on a mounting rail having a pair of flanges on either side thereof, a base member carrying the electric device is provided with a first pawl for engagement with one of the flanges and a slider slidably supported by the base is provided with a second pawl for engagement with the other flange of the mounting rail. The slider can move away from and toward the first engagement pawl and is normally urged toward the first engagement pawl by a spring member to permit snap mount of the electric device on the mounting rail. This spring member typically consisted of a compression coil spring, and the use of such a compression coil spring resulted in a structure which is highly complex and difficult to assemble. It may be possible to use a spring member which is integrally formed in the slider. However, because of restrictions on the shape of such a spring member, the size of the mounting structure, in particular, its lateral dimension, tended to be larger than desired. Also, such a spring member must be durable, but since the slider is typically made of synthetic resin ensuring a sufficient mechanical strength to the spring member presented a difficult design problem.

## BRIEF SUMMARY OF THE INVENTION

In view of such problems with conventional and conceivable mounting structures for electric devices, a primary object of the present invention is to provide a mounting structure for electric devices which is simple in structure and compact in size.

A second object of the present invention is to provide a mounting structure for electric devices which is compact and durable.

These and other objects of the present invention can be accomplished by providing a structure for mounting an electric device on a rail having a pair of flanges on either side thereof, comprising: a base member having a mounting surface adapted to abut major surfaces of the flanges; at least one first engagement pawl provided on one end of the mounting surface for engaging one of the flanges; a slider retained by guide means provided in a part of the mounting surface opposite to the first engagement pawl so as to be slidable towards and away from the first engagement pawl; biasing means for urging the slider toward the first engagement pawl; and at least one second engagement pawl provided on the slider opposite to the first engagement pawl so as to engage the other flange of the mounting rail, the second engagement pawl being provided with an inclined surface on its surface facing away from the mounting surface so that the second engagement pawl, along with the slider, may be moved away from the first engagement pawl when the one flange of the mounting rail is engaged by the first engagement pawl and the other flange of the mounting rail is pressed upon the inclined surface, and the second engagement pawl may come into full engagement with the second engagement pawl when the other flange has ridden over the inclined surface; wherein the biasing means comprises an elastic extension member extending from the slider away from the first engagement pawl and being curved into a recess provided in the mounting surface, and a free end of the elastic extension member abutting an inner surface of the recess.

Since the elastic extension member is integrally provided in the slider, the number of component parts is kept small and the assembly work is simplified. Furthermore, since the elastic extension member extends into the mounting surface, the dimension of the device main body in the direction perpendicular to the sliding direction is not affected by the presence of the elastic extension member, and the thickness or the width of the device main body may be reduced. According to a preferred embodiment of the present invention, the slider consists of a rectangular and annular member defining a central opening and the elastic extension member extends from an inner surface of the opening facing away from the first engagement pawl.

To reduce the possibility of breaking the elastic extension member by deforming it beyond its elastic limit, the slider may be further provided with projection means which is adapted to abut a stopper surface when the slider is moved away from the first engagement pawl to such an extent that the elastic extension member has elastically deformed to a maximum extent. To simplify the structure of the guide means and to reduce the overall dimensions, the guide means may comprise a pair of longitudinal walls projecting from the mounting surface and provided with a pair of longitudinal slots in their opposing surfaces, and the projection means may comprise a pair of second extension members extending from either side of the slider into openings provided in the mounting surface, base portions of the second extension members being adapted to be received in the longitudinal slots to guide the slider towards and away from the first engagement pawl.

BRIEF DESCRIPTION OF THE DRAWINGS

Now the present invention is described in the following in terms of a specific embodiment with reference to the appended drawings, in which:

Figure 1 is an exploded perspective view of a preferred embodiment of the mounting structure for electric devices according to the present invention;

Figure 2 is a fragmentary side view of the embodiment shown in Figure 1;

Figures 3a and 3b are fragmentary sectional views of the elastic extension member in two different states; and

Figures 4a and 4b are fragmentary sectional views of the projection for limiting the elastic deformation of the elastic extension members in two different states.

DETAILED DESCRIPTION OF THE PREFERRED EMBODIMENT

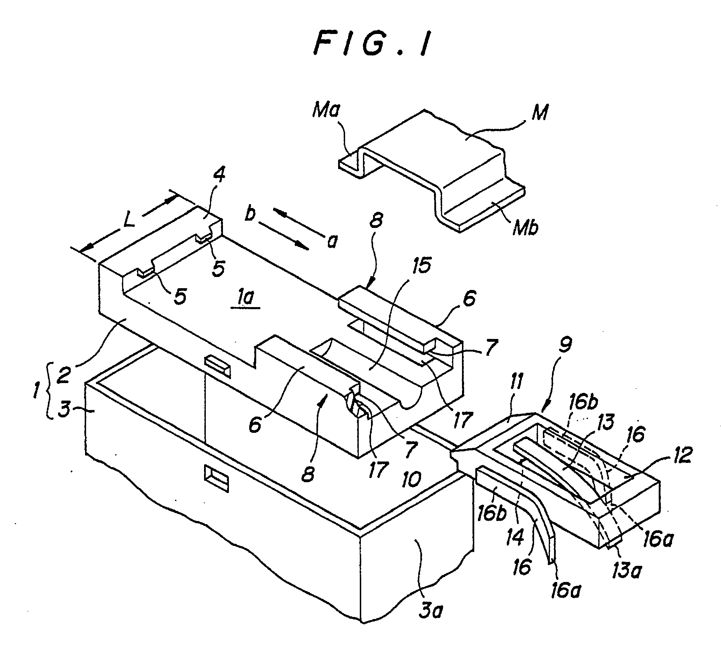

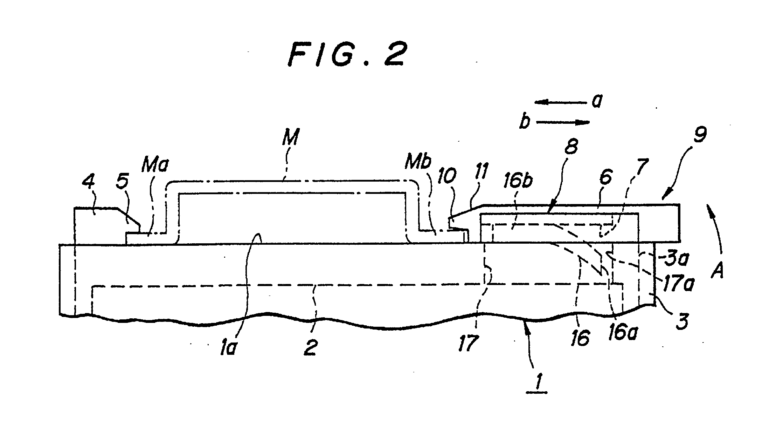

Referring to Figures 1 and 2, numeral 1 denotes a device main body such as an electromagnetic relay comprising a planar and rectangular base 2 made of synthetic resin and a box-shaped cover made of synthetic resin and adapted to be fitted on the base 2, and the bottom surface of the base 2 defines a mounting surface 1a for a mounting rail M having a pair of flanges Ma and Mb on either side thereof. A part of the mounting surface 1a located on one longitudinal end (front end) thereof is provided with an upright wall 4 extending substantially over its entire width and a pair of engagement pawls 5 are provided on a rear end of the upright wall 4 so as to be detachably engaged with one of the flanges Ma of the mounting rail M.

The other longitudinal end (rear end) of the base 2 is provided with a pair of upright walls 6 extending longitudinally on either side end of the mounting surface 1a, and the opposing surfaces of the upright walls 6 are provided with slide slots 7. The upright walls 6 and the slide slots 7 form a pair of guide units 8.

Numeral 9 denotes a slider consisting of a rectangular and annular member made of synthetic resin and retained between the guide units 8 so as to be slidable along a longitudinal direction, and its front end is provided with an engagement projection 10 which can detachably engage with the other flange Mb of the mounting rail M. Numeral 11 denotes an inclined surface formed on the engagement projection 10 for guiding the other flange Mb into a position for engagement.

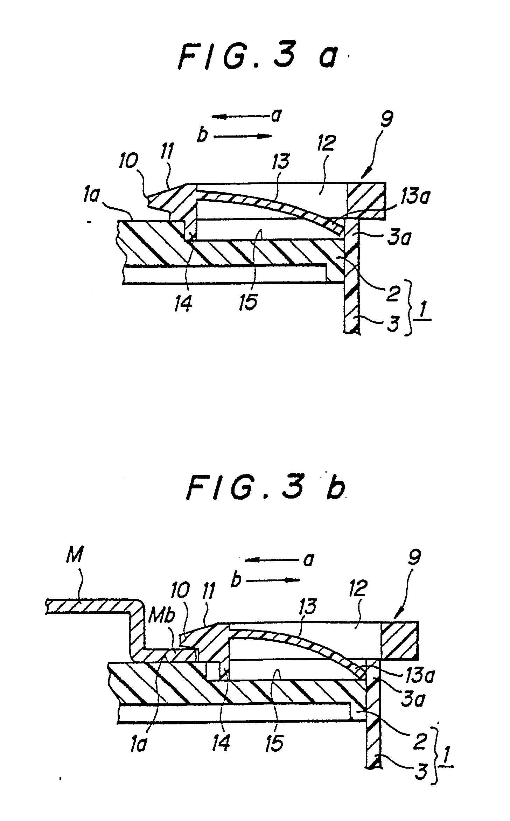

The inner wall surface of a front part of a central opening 12 of the slider is integrally provided with an elastic projecting piece 13 which projects rearwards to urge the slider 9 away from the engagement pawls 5, and its free end 13a is curved and extends into the sliding surface of the slider 9 or a recess 15 providing in the mounting surface 1a as illustrated in Figure 3a. The recess 15 in this case is defined as a longitudinal slot extending to the rear end of the base 2. Numeral 14 denotes a projection projecting from the slider 9 towards the mounting surface 1a.

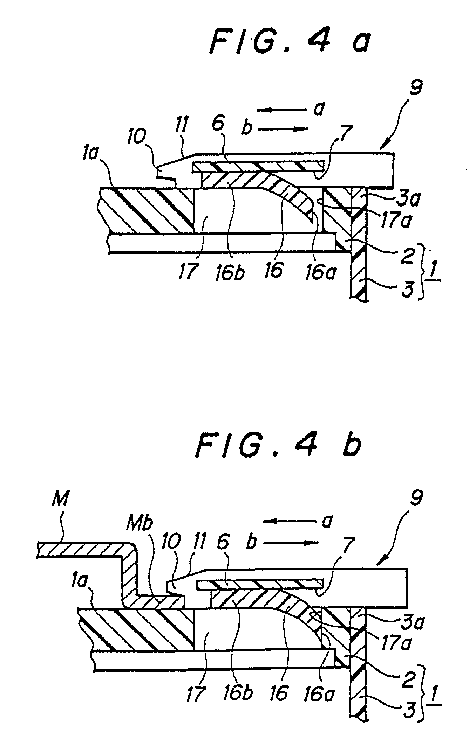

The rear surface 3a of the cover 3 defines a stopper portion which applies a forward elastic restoring force to the slider 9 by elastically deforming the elastic projecting piece 13 when the engagement projection 10 has engaged with the other flange Mb of the mounting rail M and the slider 9 has moved backward. Numeral 16 denotes movement restricting pieces which project rearward from either side portion of the slider 9 in such a manner that their free ends 16a are received in openings 17 formed in the mounting surface 1a as illustrated in Figure 4a, and control the elastic deformation of the elastic projecting piece 13 by engaging with the rear inner surfaces 17a of the openings 17 when the slider 9 has moved excessively backwards. The base end portions 16 of the movement restricting pieces 16 serve as projections which are to be received by the slide slots 7.

Now the mode of operation of the above described structure is described in the following.

When the base end portions 16b of the movement restricting pieces 16 are fitted into the associated slide slots 7 while the projection 14 of the slider 9 is received by the recess 15 of the mounting surface 1a, the free end 13a of the elastic projecting piece 13 rides over the end portion of the rear wall 3a of the cover 3 as illustrated in Figure 3a and the slider 9 is slidably received between the slider units 8. At the same time, the free end 13a of the elastic projecting piece 13 abuts the inner surface of the rear wall 3a while the free ends 16a of the movement restricting pieces 16 are received in the openings 17 as illustrated in Figure 4a.

When the engagement projections 5 are engaged with the one flange Ma of the mounting rail M, the device main body 1 is turned around this engaged portion in the direction indicated by the arrow A in Figure 2 until the engagement projection 10 of the slider 9 is engaged by the other flange Mb of the mounting rail M.

More specifically, as the inclined surface 11 of the slider 9 presses upon the other flange Mb, the slider 9 initially moves backward in the direction indicated by the arrow b by elastically deforming the elastic projecting piece 13. Once the inclined surface 11 has completely ridden over the other flange Mb, the elastic projecting piece 13 is subjected to an elastic restoring force directed in the direction indicated by the arrow a and the other flange Mb comes into full engagement with the engagement projection 10 as illustrated in Figure 3a to finally mount the device main body 1 on the mounting rail M.

When a rear portion of the slider 9 is pulled rearwards against the elastic restoring force of the elastic projecting piece 13, the engagement of the slider 9 is released, and the device main body 1 can then be removed from the mounting rail M.

Since the elastic projecting piece 13 for giving a forward elastic restoring force to the slider 9 is integrally provided in the slider 9, the number of component parts is reduced, and the efficiency of assembly work is improved. In particular, since the free end 13a of the elastic projecting piece 13 projects into the sliding surface, the lateral dimension L of the device main body 1 can be reduced without being affected by the direction in which the elastic projecting piece 13 extends and the thickness of the device main body 1 can be reduced, as compared with conventional structures.

The slider 9 is moved rearward when removing the device main body 1 from the mounting rail M, and if this rearward movement is excessive the elastic limit of the elastic projecting piece 13 may be exceeded. In view of this problem, the above described embodiment can effectively prevent breakage of the elastic projecting piece 13 due to its excessive deformation in excess of its elastic limit by means of the free ends 16a of the movement restricting pieces 16 abutting the inner rear wall surface 17a of the openings 17 when the slider 9 is moved excessively rearward.

The stopper for the elastic projecting piece 13 consisted of the rear wall 3a of the cover 3 in the above described embodiment, but it is also possible to provide a stopper in the base 2.

## Claims

1. A structure for mounting an electric device on a rail having a pair of flanges on either side thereof, comprising:
a base member having a mounting surface adapted to abut major surfaces of said flanges;
at least one first engagement pawl provided on one end of said mounting surface for engaging one of said flanges;
a slider retained by guide means provided in a part of said mounting surface opposite to said first engagement pawl so as to be slidable towards and away from said first engagement pawl;
biasing means for urging said slider toward said first engagement pawl; and
at least one second engagement pawl provided on said slider opposite to said first engagement pawl so as to engage the other flange of said mounting rail, said second engagement pawl being provided with an inclined surface on its surface facing away from said mounting surface so that said second engagement pawl, along with said slider, may be moved away from said first engagement pawl when said one flange of said mounting rail is engaged by said first engagement pawl and said other flange of said mounting rail is pressed upon said inclined surface, and said second engagement pawl may come into full engagement with said second engagement pawl when said other flange has ridden over said inclined surface;
wherein said biasing means comprises an elastic extension member extending from said slider away from said first engagement pawl and being curved into a recess provided in said mounting surface, and a free end of said elastic extension member abutting an inner surface of said recess.

2. A structure for mounting an electric device according to claim 1, wherein said slider consists of a rectangular and annular member defining a central opening and said elastic extension member extends from an inner surface of said opening facing away from said first engagement pawl.

3. A structure for mounting an electric device according to claim 3, wherein said recess provided in said mounting surface consists of a slot, and a stopper surface for said elastic extension member is defined by a cover member fitted upon said base member.

4. A structure for mounting an electric device according to claim 1, wherein said slider is further provided with projection means which is adapted to abut a stopper surface when said slider is moved away from said first engagement pawl to such an extent that said elastic extension member has elastically deformed to a maximum extent.

5. A structure for mounting an electric device according to claim 1, wherein said guide means comprises a pair of longitudinal walls projecting from said mounting surface and provided with a pair of longitudinal slots in their opposing surfaces, and said projection means comprises a pair of second extension members extending from either side of said slider into openings provided in said mounting surface, base portions of said second extension members being adapted to be received in said longitudinal slots to guide said slider towards and away from said first engagement pawl.

F I G . 1

# FIG. 2

EP 0 373 627 A1

# FIG. 3 a

# FIG. 3 b

# FIG. 4 a

# FIG. 4 b

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | DE-U-6601556 (BUSCH-JAEGER)<br>* page 2, last paragraph - page 3, last paragraph; figures 1-3 * | 1, 2 | H02B1/052 |
| A | DE-A-3513762 (B.B.C. AG)<br>* page 11, line 32 - page 14, line 8; figures 1-3 * | 1, 2, 4, 5 | |
| A | DE-A-2712893 (E.DOLD & SÖHNE KG)<br>* page 12, line 1 - page 15, line 5; figures 1-4 * | 1, 2 | |
| A | US-A-4671697 (I.ANDO ET AL)<br>* abstract; figures 4-9 * | 1, 2, 4 | |

TECHNICAL FIELDS SEARCHED (Int. Cl.5 )

H02B
H01R

The present search report has been drawn up for all claims

| Place of search | Date of completion of the search | Examiner |
|---|---|---|
| THE HAGUE | 14 MARCH 1990 | WOODALL C.G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)